# EUROPEAN PATENT SPECIFICATION

(11) **EP 2 342 266 B1**
(45) Date of publication and mention of the grant of the patent: **22.08.2018**
(21) Application number: 09816442.9
(22) Date of filing: 25.09.2009
(51) Int. Cl.: C08J 5/18, C08G 73/10, C08L 79/08, H01L 21/02, H05K 1/03

(54) **POLYIMIDE FILM**
POLYIMIDFOLIE
FILM DE POLYIMIDE

(30) Priority: 26.09.2008 KR 20080094564; 26.09.2008 KR 20080094565; 22.09.2009 KR 20090089713
(43) Date of publication of application: 13.07.2011
(73) Proprietor: Kolon Industries, Inc., Gwacheon-si, Gyeonggi-do 13837 (KR)
(72) Inventor: CHO, Han Moon, Suwon-si Gyeonggi-do 440-200 (KR); PARK, Hyo Jun, Yongin-si Gyeonggi-do 448-160 (KR); JEONG, Young Han, Daegu 706-034 (KR)
(74) Representative: Ter Meer Steinmeister & Partner
(86) International application number: PCT/KR2009/005475
(87) International publication number: WO 2010/036049

(56) References cited:
- EP-A1- 2 178 952
- WO-A1-2009/025479
- KR-A- 20070 058 812
- KR-A- 20070 121 727
- KR-A- 20080 055 531
- US-A- 5 480 964
- US-A- 5 605 942
- US-A- 5 649 045
- US-A1- 2002 074 686
- US-A1- 2003 064 235

## Description

### Technical Field

The present invention relates to a polyimide film which is colorless and transparent and suppresses dimensional change due to thermal stress.

### Background Art

Polyimide resin, which is insoluble, infusible and resistant to very high heat, has superior properties regarding such as thermal oxidation resistance, heat resistance, radiation resistance, low-temperature resistance, and chemical resistance, and is thus used in various fields of application, including advanced heat resistant materials such as automobile materials, aircraft materials, or spacecraft materials, and electronic materials such as insulation coating agents, insulating films, semiconductors, or the electrode protective films of TFT-LCDs. Recently, polyimide resin is also used for display materials, such as optical fibers or liquid crystal alignment layers, and transparent electrode films, in which conductive filler is contained in the film or is applied onto the surface of the film.

However, polyimide resin is typically disadvantageous because it has a high aromatic ring density, and thus is colored brown or yellow, undesirably resulting in low transmittance in the visible light range. Polyimide resin also suffers because light transmittance is decreased attributable to the yellow-like color thereof, thus making it difficult to apply the polyimide resin to fields requiring transparency.

Therefore, many attempts to improve the color and transmittance of a polyimide film have been made. However, as the color and transmittance of the film are improved, heat resistance thereof is undesirably reduced.

Moreover, in various electrical and electronic material fields to which the polyimide film is applied, a film is required to have high transparency and high heat resistance while being multifunctional as well.

US 5 605 942 A discloses in Example 10 (with back-reference to Example 8) a polyimide film obtained by reacting 2,2'-TFDB as a diamine with 6-FDA as an acid dianhydride, thus obtaining a polyamic acid and then imidizing the polyamic acid. The thus obtained polyimide film has a peak top residing in a temperature range from 280 to 380°C in a tanδ curve and an average transmittance of 85% or more at 400 to 740 nm.

US 2003/064235 A1 describes methods for providing a polyimide optical component. In Example B9, a polyimide film is formed by reacting 2,2'-TFDB and 6-FDA.

US 5 480 964 A relates to a negative birefringent film, useful in liquid crystal displays, and a method for controlling the negative birefringence of a polyimide film. In Example 5, a polyimide film is formed by reaction of 6-FDA and 2,2'-TFDB.

US 5 649 045 A describes polyimide optical waveguide structures comprising a core within a cladding wherein at least one of the core and the cladding is a polyimide containing 6-FDA, and the complementary portion of the waveguide structure is a polyimide having partial replacement of the 6-FDA of the core or cladding composition by BPDA.

WO 2009/025479 A1 describes in Example 3 a polyimide film obtained by reacting 2,2'-TFDB as a diamine with 6-FDA as an acid dianhydride, thus obtaining a polyamic acid and then imidizing the polyamic acid, wherein the polyimide film has a Tg of 315°C and a light transmittance between 380 and 780 nm of 90.3% for a film thickness of 50 µm. WO 2009/017330 A1 describes in Example 1 a polyimide film obtained by reacting TFDB as a diamine with 6-FDA and BPDA as acid dianhydrides, thus obtaining a polyamic acid and then imidizing the polyamic acid, wherein the polyimide film has a light transmittance between 380 and 780 nm of 87,07% for a film thickness of 100 µm.

### Disclosure of Invention

### Technical Problem

Accordingly, the present invention is intended to provide a polyimide film, which is transparent and is very heat resistant.

### Solution to Problem

An aspect of the present invention provides a polyimide film, which is manufactured by reacting a diamine with an acid dianhydride thus obtaining a polyamic acid and then imidizing the polyamic acid, and which has a peak top residing in a temperature range from 280°C to 380°C in a tanδ curve obtained by dividing a loss modulus by a storage modulus and an average transmittance of 85% or more at 400 ∼ 740 nm measured using a UV spectrophotometer at a film thickness of 50 ∼ 100 µm,
wherein the diamine comprises 2,2'-bis(trifluoromethyl)-4,4'-diaminobiphenyl,
wherein the acid dianhydride comprises 2,2-bis(3,4-dicarboxyphenyl)hexafluoropropane dianhydride, and one or more selected from the group consisting of pyromellitic dianhydride, biphenyltetracarboxylic dianhydride, and oxydiphthalic dianhydride,
wherein when obtaining the polyamic acid, 2,2-bis(3,4-dicarboxyphenyl)hexafluoropropane dianhydride is added after the remaining acid dianhydride,
wherein the tanδ curve has a second peak residing in a temperature range from 200°C to 300°C.

In this aspect, the peak top may reside in a temperature range from 320°C to 360°C.

In this aspect, the polyimide film may have color coordinates in which L is 90 or more, a is 5 or less and b is 5 or less, measured using a UV spectrophotometer at a film thickness of 50 ∼ 100 *µ*m.

In this aspect, the polyimide film may have an average coefficient of linear thermal expansion of 70 ppm/°C or less, measured in a temperature range of 50 ∼ 250°C using a thermomechanical analysis method at a film thickness of 50 ∼ 100 *µ*m.

In this aspect, the acid dianhydride comprises 2,2-bis (3 ,4-dicarboxyphenyl)hexafluoropropane dianhydride.

As such, the acid dianhydride may include 30 ∼ 100 mol% of 2,2-bis(3,4-dicarboxyphenyl)hexafluoropropane dianhydride.

In this aspect, the acid dianhydride further comprises one or more selected from the group consisting of pyromellitic dianhydride, biphenyltetracarboxylic dianhydride, and oxydiphthalic dianhydride.

In this aspect, the diamine comprises 2,2'-bis(trifluoromethyl)-4,4'-diaminobiphenyl.

As such, the diamine may include 20 ∼ 100 mol% of 2,2'-bis(trifluoromethyl)-4,4'-diaminobiphenyl.

In this aspect, when obtaining the polyamic acid, when obtaining the polyamic acid, 2,2-bis(3,4-dicarboxyphenyl)hexafluoropropane dianhydride is added after the remaining acid dianhydride.

In this aspect, the reaction between the diamine and the acid dianhydride may be performed for 3 ∼ 24 hours.

The polyimide film according to an embodiment of the present invention is very transparent and highly resistant to heat and thus undergoes little dimensional change under thermal stress, so that it is expected to be useful in transparent conductive films, TFT substrates, flexible printed circuit boards, etc.

### Best Mode for Carrying out the Invention

Hereinafter, a detailed description will be given of the present invention.

According to an embodiment of the present invention, a polyimide film has tanδ which is a value obtained by dividing a loss modulus by a storage modulus and which has a peak top residing in a temperature range of 280 ∼ 380°C, in terms of satisfying heat resistance.

The peak top of tanδ designates a temperature range actually related to the dimensional change of a film. In the case where the peak top of tanδ resides in a temperature range below the above lower limit, the polyimide film may undergo dimensional change under thermal conditions in application fields thereof such as electrical and electronic materials. In contrast, in the case where the peak top of tanδ resides in a temperature range exceeding the above upper limit, the polymeric structure of the film becomes very dense, undesirably deteriorating optical properties thereof. Hence, the polyimide film according to the present invention has the peak top of tanδ, residing in a temperature range of 280 ∼ 380°C, preferably 300 ∼ 360°C, and more preferably 320 ∼ 360°C.

Also, the polyimide film according to the embodiment of the present invention has an average transmittance of 85% or more at 400 ∼ 740 nm, measured using a UV spectrophotometer at a film thickness of 50 ∼ 100 *µ*m, in terms of ensuring transparency. If the average transmittance at 400 ∼ 740 nm measured using a UV spectrophotometer at a film thickness of 50 ∼ 100 *µ*m is less than 85%, there may occur a problem in which the polyimide film does not exhibit appropriate viewing effects when applied to a display.

The polyimide film according to the embodiment of the present invention has a second peak in a temperature range lower than the temperature range of the peak top in the tanδ curve obtained by dividing a loss modulus by a storage modulus, in terms of ensuring transparency and satisfying heat resistance.

The peak top in the tanδ curve designates a temperature range actually related to the dimensional change of a film. In the case of a general polyimide film, the peak of the tanδ curve resides in a single temperature range.

However, the polyimide film according to the embodiment of the present invention has the tanδ curve having the peak top in a predetermined temperature range and the second peak in a temperature range lower than the temperature range of the peak top. This phenomenon is considered to be due to the mobility of a functional group on the side chain of the polymer. Thus in order to induce the mobility of the functional group on the side chain of the polymer, the functional group of the side chain should form a bulky free volume. In this case, optical transmittance is increased, thus improving transparency. Thereby, a transparent film can be ensured.

However, when the temperature range of the second peak in the tanδ curve is too low, the thermal properties of a side chain or soft group of the monomer itself are low, and therefore the overall thermal properties of the film may be deteriorated. In contrast, when the temperature range of the second peak is too high, the free volume is excessively enlarged by the large side chain of the monomer, undesirably causing defects in terms of the structural stability of the film. Hence, the polyimide film according to the embodiment of the present invention has the second peak in the tanδ curve, residing in a temperature range from 200°C to 300°C.

The polyimide film having the tanδ curve having the peak top and the second peak in predetermined temperature ranges can satisfy transparency or heat resistance.

Also unlike a general colored polyimide film, the polyimide film according to the embodiment of the present invention has color coordinates, in which L is 90 or more, a is 5 or less and b is 5 or less, measured using a UV spectrophotometer at a film thickness of 50 ∼ 100 *µ*m.

In consideration of an influence on the dimensional change, the polyimide film preferably has an average coefficient of linear thermal expansion (CTE) of 70 ppm/°C or less, measured in a temperature range of 50 ∼ 250°C using a thermomechanical analysis method at a film thickness of 50 ∼ 100 *µ*m. If the CTE is higher than the above upper limit, the CTE of the polyimide film manufactured into an adhesive film is excessively increased, and a difference thereof from the CTE of metal foil is also increased, causing dimensional change.

The polyimide film preferably has an average CTE of 15 ∼ 60 ppm/°C.

The polyimide film according to the embodiment of the present invention is obtained by polymerizing an acid dianhydride and a diamine, thus preparing a polyamic acid, which is then imidized.

Preferably, the polyimide film according to the embodiment of the present invention is manufactured through a manufacturing process including reacting a diamine and an acid dianhydride in an organic solvent, thus obtaining a polyamic acid solution, imidizing the polyamic acid solution, and forming the imidized solution into a polyimide film.

More specifically, the polyimide film according to the present invention is obtained from a polyamic acid solution which is a precursor of polyimide. The polyamic acid solution is prepared by dissolving a diamine and an acid dianhydride, for example, an aromatic diamine and an aromatic acid dianhydride, in substantially equimolar amounts in an organic solvent, and then polymerizing the solution thus obtained.

The transparency and/or heat resistance of the polyimide film according to the present invention are controllable by controlling the structures of diamine and acid dianhydride which are monomers thereof or by controlling the order of adding the monomers.

Taking into consideration transparency, the acid dianhydride includes 2,2-bis(3,4-dicarboxyphenyl)hexafluoropropane dianhydride (6-FDA). In addition, one or more selected from among 4-(2,5-dioxotetrahydrofuran-3-yl)-1,2,3,4-tetrahydronaphthalene-1,2-dicarboxylic anhydride (TDA), and 4,4'-(4,4'-isopropylidenediphenoxy)bis(phthalic anhydride) (HBDA) may be further included. In consideration of heat resistance, one or more selected from among pyromellitic dianhydride (PMDA), biphenyltetracarboxylic dianhydride (BPDA), and oxydiphthalic dianhydride (ODPA) is additionally used.

When 6-FDA is contained in an amount of 30 ∼ 100 mol% in the acid dianhydride, transparency may be exhibited and simultaneously the other properties including heat resistance may not be deteriorated.

Also, the diamine comprises 2,2'-bis(trifluoromethyl)-4,4'-diaminobiphenyl (2,2'-TFDB) and may further include one or more selected from among 2,2-bis[4-(4-aminophenoxy)-phenyl]propane (6HMDA), 3,3'-bis(trifluoromethyl)-4,4'-diaminobiphenyl (3,3'-TFDB), 4,4'-bis(3-aminophenoxy)diphenylsulfone (DBSDA), bis(3-aminophenyl)sulfone (3DDS), bis(4-aminophenyl)sulfone (4DDS), 1,3-bis(3-aminophenoxy)benzene (APB-133), 1,4-bis(4-aminophenoxy)benzene (APB-134), 2,2'-bis[3(3-aminophenoxy)phenyl]hexafluoropropane (3-BDAF), 2,2'-bis[4(4-aminophenoxy)phenyl]hexafluoropropane (4-BDAF), 2,2'-bis(3-aminophenyl)hexafluoropropane (3,3'-6F), 2,2'-bis(4-aminophenyl)hexafluoropropane (4,4'-6F) and oxydianiline (ODA). Particularly useful is 2,2'-TFDB in terms of ensuring an appropriate free volume due to the side chain.

Preferably, when 2,2'-TFDB is contained in an amount of 20 ∼ 100 mol% in the diamine, transparency may be maintained because of the free volume ensured by the side chain.

The method of manufacturing the polyimide film using the monomers is not particularly limited. For example, the polyimide film may be manufactured by polymerizing an aromatic diamine and an aromatic dianhydride in a first solvent, thus obtaining a polyamic acid solution, imidizing the polyamic acid solution, mixing the imidized solution with a second solvent, filtering and drying the mixture solution, thus obtaining a solid polyimide resin, dissolving the solid polyimide resin in the first solvent, thus preparing a polyimide solution, which is then subjected to a film forming process. In this case, the second solvent may have lower polarity than the first solvent. Specifically, the first solvent may be one or more selected from among m-cresol, N-methyl-2-pyrrolidone (NMP), dimethylformamide (DMF), dimethylacetamide (DMAc), dimethylsulfoxide (DMSO), acetone and diethyl acetate, and the second solvent may be one or more selected from among water, alcohols, ethers and ketones.

The heat resistance of the film may be controlled by controlling the order of adding the monomers. The polymerization is performed by adding 6-FDA among acid dianhydrides after the remaining acid dianhydride. Thereby the temperature of the peak top in the tanδ curve may be advantageously increased.

Furthermore, the heat resistance of the film may be controlled depending on the polymerization time. As the polymerization time is increased, the temperature of the peak top in the tanδ curve may be increased. However, if the polymerization time is too long, the molecular weight of the resultant polymer may be reduced attributable to depolymerization, thus deteriorating thermal stability (e.g. CTE). In contrast, if the polymerization time is too short, the molecular weight distribution (PDI) is excessively wide, undesirably deteriorating the mechanical properties of the film. Hence, the polymerization time may be set to 3 ∼ 24 hours.

### Mode for the Invention

A better understanding of the present invention may be obtained through the following examples, which are set forth to illustrate, but are not to be construed as limiting the present invention.

### EXAMPLE 1 (reference example)

While nitrogen was passed through a 200 mℓ three-neck round-bottom flask reactor equipped with a stirrer, a nitrogen injector, a dropping funnel, a temperature controller and a condenser, 88.13 g of N,N-dimethylacetamide (DMAc) was added into the reactor, and 9.6 g of 2,2'-bis(trifluoromethyl)-4,4'-diaminobiphenyl (2,2'-TFDB) was then dissolved therein. The temperature of the reactor was decreased to 10°C, after which 10.66 g of 6-FDA and 1.765 g of biphenyltetracarboxylic dianhydride (BPDA) were sequentially added thereto. This solution was stirred at room temperature for 3 hours.

After the completion of the reaction, the produced polyamic acid solution was mixed with 4.75 g of pyridine and 6.13 g of acetic anhydride, stirred for 30 min, further stirred at 80°C for 2 hours, and cooled to room temperature. The solution thus cooled was slowly added into a vessel containing 1 ℓ of methanol and thus precipitated. The precipitated solid was filtered, milled, and then dried in a vacuum at 80°C for 6 hours, thus obtaining solid powder, which was then dissolved in N,N-dimethylacetamide (DMAc), thus obtaining a 20 wt% solution.

The solution thus obtained was applied on a stainless steel plate, cast to a thickness of 700 *µ*m, and dried for 1 hour using hot air at 150°C, after which the resulting film was peeled off from the stainless steel plate and then secured to a frame with pins.

The frame having the film secured thereto was placed in a vacuum oven, slowly heated from 100°C to 300°C for 2 hours, and then gradually cooled, after which the film was separated from the frame, thereby obtaining a polyimide film. Thereafter, as a final heat treatment process, the polyimide film was thermally treated at 300°C for 30 min (thickness 100 *µ*m).

### EXAMPLE 2 (reference example)

While nitrogen was passed through a 200 mℓ three-neck round-bottom flask reactor equipped with a stirrer, a nitrogen injector, a dropping funnel, a temperature controller and a condenser, 88.13 g of N,N-dimethylacetamide (DMAc) was added into the reactor, and 9.6 g of 2,2'-bis(trifluoromethyl)-4,4'-diaminobiphenyl (2,2'-TFDB) was then dissolved therein. The temperature of the reactor was decreased to 10°C, after which 10.66 g of 6-FDA and 1.765 g of biphenyltetracarboxylic dianhydride (BPDA) were sequentially added thereto. This solution was stirred at room temperature for 12 hours.

After the completion of the reaction, the produced polyamic acid solution was mixed with 4.75 g of pyridine and 6.13 g of acetic anhydride, stirred for 30 min, further stirred at 80°C for 2 hours, and cooled to room temperature. The solution thus cooled was slowly added into a vessel containing 1 ℓ of methanol and thus precipitated. Thereafter, the precipitated solid was filtered, milled, and then dried in a vacuum at 80°C for 6 hours, thus obtaining solid powder, which was then dissolved in N,N-dimethylacetamide (DMAc), thus obtaining a 20 wt% solution.

The same subsequent procedures as in Example 1 were performed, thus manufacturing a polyimide film.

### EXAMPLE 3 (reference example)

While nitrogen was passed through a 200 mℓ three-neck round-bottom flask reactor equipped with a stirrer, a nitrogen injector, a dropping funnel, a temperature controller and a condenser, 88.13 g of N,N-dimethylacetamide (DMAc) was added into the reactor, and 9.6 g of 2,2'-bis(trifluoromethyl)-4,4'-diaminobiphenyl (2,2'-TFDB) was then dissolved therein. The temperature of the reactor was decreased to 10°C, after which 10.66 g of 6-FDA and 1.765 g of biphenyltetracarboxylic dianhydride (BPDA) were sequentially added thereto. This solution was stirred at room temperature for 24 hours.

After the completion of the reaction, the produced polyamic acid solution was mixed with 4.75 g of pyridine and 6.13 g of acetic anhydride, stirred for 30 min, further stirred at 80°C for 2 hours, and cooled to room temperature. The solution thus cooled was slowly added into a vessel containing 1 ℓ of methanol and thus precipitated. Thereafter, the precipitated solid was filtered, milled, and then dried in a vacuum at 80°C for 6 hours, thus obtaining solid powder, which was then dissolved in N,N-dimethylacetamide (DMAc), thus obtaining a 20 wt% solution.

The same subsequent procedures as in Example 1 were performed, thus manufacturing a polyimide film.

### EXAMPLE 4 (example according to claim 1)

While nitrogen was passed through a 200 mℓ three-neck round-bottom flask reactor equipped with a stirrer, a nitrogen injector, a dropping funnel, a temperature controller and a condenser, 88.13 g of N,N-dimethylacetamide (DMAc) was added into the reactor, and 9.6 g of 2,2'-bis(trifluoromethyl)-4,4'-diaminobiphenyl (2,2'-TFDB) was then dissolved therein. The temperature of the reactor was decreased to 10°C, after which 1.765 g of biphenyltetracarboxylic dianhydride (BPDA) and 10.66 g of 6-FDA were sequentially added thereto. This solution was stirred at room temperature for 3 hours.

After the completion of the reaction, the produced polyamic acid solution was mixed with 4.75 g of pyridine and 6.13 g of acetic anhydride, stirred for 30 min, further stirred at 80°C for 2 hours, and cooled to room temperature. The solution thus cooled was slowly added into a vessel containing 1 ℓ of methanol and thus precipitated. Thereafter, the precipitated solid was filtered, milled, and then dried in a vacuum at 80°C for 6 hours, thus obtaining solid powder, which was then dissolved in N,N-dimethylacetamide (DMAc), thus obtaining a 20 wt% solution.

The same subsequent procedures as in Example 1 were performed, thus manufacturing a polyimide film.

### EXAMPLE 5 (example according to claim 1)

While nitrogen was passed through a 200 mℓ three-neck round-bottom flask reactor equipped with a stirrer, a nitrogen injector, a dropping funnel, a temperature controller and a condenser, 88.13 g of N,N-dimethylacetamide (DMAc) was added into the reactor, and 9.6 g of 2,2'-bis(trifluoromethyl)-4,4'-diaminobiphenyl (2,2'-TFDB) was then dissolved therein. The temperature of the reactor was decreased to 10°C, after which 1.765 g of biphenyltetracarboxylic dianhydride (BPDA) and 10.66 g of 6-FDA were sequentially added thereto. This solution was stirred at room temperature for 12 hours.

After the completion of the reaction, the produced polyamic acid solution was mixed with 4.75 g of pyridine and 6.13 g of acetic anhydride, stirred for 30 min, further stirred at 80°C for 2 hours, and cooled to room temperature. The solution thus cooled was slowly added into a vessel containing 1 ℓ of methanol and thus precipitated. Thereafter, the precipitated solid was filtered, milled, and then dried in a vacuum at 80°C for 6 hours, thus obtaining solid powder, which was then dissolved in N,N-dimethylacetamide (DMAc), thus obtaining a 20 wt% solution.

The same subsequent procedures as in Example 1 were performed, thus manufacturing a polyimide film.

### EXAMPLE 6 (example according to claim 1)

While nitrogen was passed through a 200 mℓ three-neck round-bottom flask reactor equipped with a stirrer, a nitrogen injector, a dropping funnel, a temperature controller and a condenser, 88.13 g of N,N-dimethylacetamide (DMAc) was added into the reactor, and 9.6 g of 2,2'-bis(trifluoromethyl)-4,4'-diaminobiphenyl (2,2'-TFDB) was then dissolved therein. The temperature of the reactor was decreased to 10°C, after which 1.765 g of biphenyltetracarboxylic dianhydride (BPDA) and 10.66 g of 6-FDA were sequentially added thereto. This solution was stirred at room temperature for 24 hours.

After the completion of the reaction, the produced polyamic acid solution was mixed with 4.75 g of pyridine and 6.13 g of acetic anhydride, stirred for 30 min, further stirred at 80°C for 2 hours, and cooled to room temperature. The solution thus cooled was slowly added into a vessel containing 1 ℓ of methanol and thus precipitated. Thereafter, the precipitated solid was filtered, milled, and then dried in a vacuum at 80°C for 6 hours, thus obtaining solid powder, which was then dissolved in N,N-dimethylacetamide (DMAc), thus obtaining a 20 wt% solution.

The same subsequent procedures as in Example 1 were performed, thus manufacturing a polyimide film.

### COMPARATIVE EXAMPLE 1

11.8962 g of 4,4'-diaminodiphenylmethane (MDA) and 4.3256 g of p-phenylenediamine (PDA) were dissolved in 203.729 g of N,N-dimethylformamide (DMF), and this solution was maintained at 0°C. Further, 15.511 g of 4,4'-oxydiphthalic dianhydride (ODPA) was slowly added thereto, and stirred for 1 hour, thus completely dissolving the ODPA. Further, 6.4446 g of 3,3'-4,4'-benzophenonetetracarboxylic dianhydride (BTDA) was slowly added thereto, stirred for 1 hour and thus completely dissolved, after which 6.5436 g of pyromellitic dianhydride (PMDA) was added thereto and stirred for 1 hour, thus obtaining a polyamic acid solution having a viscosity of 2500 poise at 23°C and a solid content of 18.0 wt%.

Thereafter, a filler was dispersed in the solution thus obtained in an amount of 0.01 ∼ 10 times the weight of the solution, after which this solution was stirred, defoamed for 1 hour using a vacuum pump and then cooled to 0°C. Then, 100 g of the filler-dispersed polyamic acid solution was mixed with a curing agent composed of 11.4 g of acetic anhydride, 4.8 g of isoquinoline and 33.8 g of DMF, after which this mixture was softly applied on a hard plate made of stainless steel. The resulting polyamic acid-applied hard plate was heated at 100°C for 300 sec thus obtaining a gel film. The film was peeled off from the hard plate and then secured to a frame at the margin thereof. The film thus secured was heated to 150°C, 250°C, 350°C, and 450°C for 30 ∼ 240 sec, and then further heated in a far infrared oven for 30 ∼ 180 sec, thereby obtaining a film having a thickness of 50 *µ*m.

### COMPARATIVE EXAMPLE 2

Into a 2 ℓ jacket reactor was added 995 g of a solvent for example N,N'-dimethylformamide (DMF). The temperature of the reactor was set to 30°C and 3.65 g of p-phenylenediamine (p-PDA) and 2.901 g of 4,4'-diaminophenyleneether (ODA), serving as diamines, were added thereto. This solution was stirred for about 30 min and thus monomers were confirmed to be dissolved, after which 5.64 g of 3,3'-4,4'-biphenyltetracarboxylic dianhydride (BPDA) was added thereto. The heat value of the reactor was confirmed. After the completion of the heating, the resulting solution was cooled to 30°C, after which 5.96 g of pyromellitic anhydride (PMDA) was added thereto. Thereafter, the solution was stirred for 1 hour while the temperature was maintained. After the completion of the stirring, the temperature of the reactor was increased to 40°C, and 4.98 g of a 7.2% PMDA solution was added and stirred for 2 hours while the temperature was maintained. During the stirring procedure, the internal pressure of the reactor was reduced to about 1 torr, thus defoaming the polyamic acid solution.

The polyamic acid solution thus obtained had a solid content of 18.5 wt% and a viscosity of 5300 poise. 100 g of the polyamic acid solution and 50 g of a catalyst solution (7.2 g of isoquinoline and 22.4 g of acetic anhydride) were uniformly stirred, applied on a stainless steel plate, cast to a thickness of 50 *µ*m, and dried for 5 min using hot air at 150°C, after which the resulting film was peeled off from the stainless steel plate and then secured to a frame with pins. The frame having the film secured thereto was placed in a vacuum oven, slowly heated from 100°C to 350°C for 30 min, and then gradually cooled, after which the film was separated from the frame.

The tanδ of the polyimide film of each of Examples 1 to 6 and Comparative Examples 1 and 2 was measured as described below. The results are shown in Table 1 below.

### (1) Tanδ

Using DMA Q800 available from TA Instrument, a loss modulus and a storage modulus were measured using the following test sample under the following conditions, and the loss modulus was divided by the storage modulus, thus obtaining a tanδ curve.
- Test Sample: length 15 - 20 mm, width 4 mm, thickness 50 *µ*m
- Test Mode: DMA Multi-Frequency-Strain
- Test Mode Details: (1) Clamp: Tension: Film
   (2) Strain %: 0.5%
   (3) Frequency: 1 Hz (constant in the overall temperature range)
   (4) Reload Force: 0.1N
   (5) Force Track: 125
   (6) Poissons: 0.440
- Temperature Conditions: (1) Heating Range: Room temperature ∼ 500°C, (2) Heating Rate: 5 °C/min
- Main Collection Data: (1) Storage modulus (E', (2) Loss modulus (E", (3) tanδ (E"/E')

In addition, the transmittance, color coordinates, yellowness index, and coefficient of linear thermal expansion of the polyimide film were measured as follows. The results are shown in Table 2 below.

### (2) Transmittance & Color Coordinates

The visible light transmittance of the polyimide film was measured using a UV spectrophotometer (Cary100, available from Varian).

The color coordinates of the polyimide film were measured using a UV spectrophotometer (Cary100, available from Varian) according to ASTM E1347-06. As such, a standard illuminant was CIE D65.

### (3) Yellowness Index

The yellowness index of the polyimide film was measured according to ASTM E313.

### (4) Coefficient of Linear Thermal Expansion (CTE)

The CTE of the polyimide film was measured at 50 ∼ 250°C according to a thermomechanical analysis method using a thermomechanical analyzer (Q400, available from TA Instrument).

### Table 1

### [Table 1]

**[Table]**

| | 2^{nd} Peak | | Peak Top | |
|---|---|---|---|---|
| | Temp. (°C) | Value | Temp. (°C) | Value |
| Ex. 1 | 256 | 0.14 | 325 | 1.00 |
| Ex. 2 | 252 | 0.15 | 339 | 0.97 |
| Ex. 3 | 254 | 0.15 | 333 | 0.96 |
| Ex. 4 | 254 | 0.15 | 339 | 0.90 |
| Ex. 5 | 257 | 0.16 | 345 | 1.03 |
| Ex. 6 | 252 | 0.16 | 342 | 0.96 |
| C.Ex. 1 | - | - | 374 | 0.10 |
| C.Ex. 2 | 116 | - | 323 | 0.23 |

As is apparent from the results of Table 1, the polyimide films of Examples 1 to 6 had the second peak of tanδ in the temperature range of 200 ∼ 300°C and the peak top of tanδ in the temperature range of 280 ∼ 380°C. The value of the peak top was greater than that of the second peak.

When 6-FDA was added after rather than before the remaining acid dianhydride and thus polymerized, the temperature of the peak top in the tanδ curve was further increased. Also under the same conditions, the temperature of the peak top in the tanδ curve was increased in proportion to an increase in the polymerization time.

### Table 2

### [Table 2]

**[Table]**

| | | Thick .(*µ*m) | CTE(pp m/°C) | Yellow. | Transmittance (%) | | | | | Color Coordinates | | |
|---|---|---|---|---|---|---|---|---|---|---|---|---|
| | | | | | 400nm ∼740 nm | 550 nm∼7 40nm | 550 nm | 500 nm | 420 nm | L | a | b |
| E x. | 1 | 100 | 53.6 | 3.97 | 87.8 | 90.9 | 90.4 | 89.6 | 80.0 | 96.08 | -0.87 | 2.98 |
| | 2 | 100 | 48.8 | 2.94 | 87.9 | 90.5 | 90.0 | 89.3 | 82.1 | 95.92 | -0.59 | 2.25 |
| | 3 | 100 | 44.2 | 2.78 | 87.9 | 90.4 | 89.9 | 89.3 | 82.5 | 95.9 | -0.58 | 2.13 |
| | 4 | 100 | 52.2 | 4.39 | 87.7 | 90.8 | 90.3 | 89.3 | 79.5 | 96.0 | -0.90 | 3.23 |
| | 5 | 100 | 47.9 | 2.96 | 88.0 | 90.7 | 90.3 | 89.5 | 82.1 | 96.0 | -0.62 | 2.28 |
| | 6 | 100 | 51.2 | 2.85 | 88.0 | 90.6 | 90.2 | 89.5 | 82.2 | 96.0 | -0.61 | 2.2 |
| C. E x. | 1 | 50 | 16.4 | 89.3 | 54.9 | 79.8 | 69.6 | 37.5 | 0 | 82.9 | -0.71 | 92.12 |
| | 2 | 50 | 15.2 | 89.6 | 59.1 | 85.0 | 78.8 | 42.1 | 0 | 86.5 | -3.15 | 96.4 |

As is apparent from the results of Table 2, the polyimide film according to the present invention (examples 4-6) can be seen to have high transparency and superior dimensional stability against thermal stress.

Although the film of Comparative Example 1 or 2 may ensure dimensional stability against thermal stress, its transparency is low, and thus application thereof to electrical and electronic material fields requiring transparency is not preferable.

## Claims

1. A polyimide film, which is manufactured by reacting a diamine with an acid dianhydride thus obtaining a polyamic acid and then imidizing the polyamic acid, and which has a peak top residing in a temperature range from 280°C to 380°C in a tanδ curve obtained by dividing a loss modulus by a storage modulus and an average transmittance of 85% or more at 400 ∼ 740 nm measured using a UV spectrophotometer at a film thickness of 50 ∼ 100 µm, wherein the diamine comprises 2,2'-bis(trifluoromethyl)-4,4'-diaminobiphenyl, wherein the acid dianhydride comprises 2,2-bis(3,4-dicarboxyphenyl)hexafluoropropane dianhydride, and one or more selected from the group consisting of pyromellitic dianhydride, biphenyltetracarboxylic dianhydride, and oxydiphthalic dianhydride, wherein when obtaining the polyamic acid, 2,2-bis(3,4-dicarboxyphenyl)hexafluoropropane dianhydride is added after the remaining acid dianhydride, wherein the tanδ curve has a second peak residing in a temperature range from 200°C to 300° C.

2. The polyimide film according to claim 1, wherein the peak top resides in a temperature range from 320° C to 360°C.

3. The polyimide film according to claim 1, which has color coordinates in which L is 90 or more, a is 5 or less and b is 5 or less, measured using a UV spectrophotometer at a film thickness of 50 ∼ 100 µm.

4. The polyimide film according to claim 1, which has an average coefficient of linear thermal expansion of 70 ppm/°C or less, measured in a temperature range of 50 ∼ 250°C using a thermomechanical analysis method at a film thickness of 50 ∼ 100 µm.

5. The polyimide film according to claim 1, wherein the acid dianhydride comprises 30 ∼ 100 mol% of 2,2-bis(3,4-dicarboxyphenyl)hexafluoropropane dianhydride.

6. The polyimide film according to claim 1, wherein the diamine comprises 20 ∼ 100 mol % of 2,2'-bis(trifluoromethyl)-4,4'-diaminobiphenyl.

7. The polyimide film according to claim 1, wherein the reacting is performed for 3 ∼ 24 hours.

## Patentansprüche

1. Polyimidfolie, welche hergestellt wird durch Umsetzen eines Diamins mit einem Säuredianhydrid, um eine Polyamidsäure zu erhalten, und danach Imidisieren der Polyamidsäure, und welche eine Peakspitze in einem Temperaturbereich von 280°C bis 380°C in einer tanδ-Kurve aufweist, erhalten durch Dividieren eines Verlustmoduls durch einem Lagermodul, und eine durchschnittliche Durchlässigkeit von 85% oder mehr bei 400 - 740 nm, gemessen unter Verwendung eines UV-Spektrophotometers, bei einer Foliendicke von 50 - 100 µm, aufweist, wobei das Diamin 2,2'-Bis(trifluormethyl)-4,4'-diaminobiphenyl umfasst, wobei das Säuredianhydrid 2,2-Bis(3,4-dicarboxyphenyl)hexafluorpropandianhydrid und eines oder mehrere, gewählt aus der Gruppe, bestehend aus Pyromellitsäuredianhydrid, Biphenyltetracarbonsäuredianhydrid und Oxydiphthalsäuredianhydrid, umfasst, wobei, wenn die Polyamidsäure erhalten wird, 2,2-Bis(3,4-dicarboxyphenyl)hexafluorpropandianhydrid nach dem verbleibenden Säuredianhydrid zugegeben wird, wobei die tanδ-Kurve einen zweiten Peak aufweist, der in einem Temperaturbereich von 200°C bis 300°C verweilt.

2. Polyimidfolie nach Anspruch 1, wobei die Peakspitze in einem Temperaturbereich von 320°C bis 360°C verweilt.

3. Polyimidfolie nach Anspruch 1, welche Farbkoordinaten aufweist, worin L 90 oder mehr ist, a 5 oder weniger ist, und b 5 oder weniger ist, gemessen unter Verwendung eines UV-Spektrophotometers bei einer Foliendicke von 50 - 100 µm.

4. Polyimidfolie nach Anspruch 1, welche einen durchschnittlichen linearen thermischen Ausdehnungskoeffizienten von 70 ppm/°C oder weniger aufweist, gemessen in einem Temperaturbereich von 50 - 250°C unter Verwendung einer thermomechanischen Analysenmethode bei einer Foliendicke von 50 - 100 µm.

5. Polyimidfolie nach Anspruch 1, wobei das Säuredianhydrid 30 - 100 Mol% 2,2-Bis(3,4-dicarboxyphenyl)hexafluorpropandianhydrid umfasst.

6. Polyimidfolie nach Anspruch 1, wobei das Diamin 20 - 100 Mol% 2,2'-Bis(trifluormethyl)-4,4'-diaminobiphenyl umfasst.

7. Polyimidfolie nach Anspruch 1, wobei die Umsetzung während 3 - 24 Stunden durchgeführt wird.

## Revendications

1. Un film de polyimide, qui est fabriqué en faisant réagir une diamine avec un dianhydride d'acide, obtenant ainsi un acide polyamique et puis en imidant l'acide polyamique, et qui a un pic situé dans une plage de température de 280 °C à 380 °C dans une courbe tan δ obtenue en divisant un module de perte par un module de conservation et une transmittance moyenne de 85% ou plus à 400 ∼ 740 nm mesurée en utilisant un spectrophotomètre UV à une épaisseur de film de 50 ∼ 100 µm, dans lequel la diamine comprend du 2,2'-bis(trifluorométhyl)-4,4'-diaminobiphényle, dans lequel le dianhydride d'acide comprend le dianhydride de 2,2-bis(3,4-dicarboxyphényl)hexafluoropropane et un ou plusieurs choisis parmi le groupe constitué par le dianhydride pyromellitique, le dianhydride biphényltétracarboxylique et le dianhydride oxyldiphtalique, dans lequel lors de l'obtention de l'acide polyamique, on ajoute du dianhydride de 2,2-bis(3,4-dicarboxyphényl)hexafluoropropane après le dianhydride d'acide restant, dans lequel la courbe tanδ a un second pic résidant dans une gamme de température allant de 200 °C à 300 °C.

2. Le film de polyimide selon la revendication 1, dans lequel le sommet du pic se situe dans une gamme de température de 320 °C à 360 °C.

3. Le film de polyimide selon la revendication 1, qui a des coordonnées de couleur dans lesquelles L est 90 ou plus, a est 5 ou moins et b est 5 ou moins, mesuré à l'aide d'un spectrophotomètre UV à une épaisseur de film de 50 ∼ 100 µm.

4. Le film de polyimide selon la revendication 1, qui a un coefficient moyen de dilatation thermique linéaire de 70 ppm / °C ou moins, mesuré dans une gamme de température de 50 ∼ 250 °C en utilisant un procédé d'analyse thermomécanique à une épaisseur de film de 50 ∼ 100 µm.

5. Le film de polyimide selon la revendication 1, dans lequel le dianhydride d'acide comprend de 30 ∼ 100% en moles de dianhydride de 2,2-bis(3,4-dicarboxyphényl)hexafluoropropane.

6. Le film de polyimide selon la revendication 1, dans lequel la diamine comprend du 2,2'-bis(trifluorométhyl)-4,4'-diaminobiphényle.

7. Le film de polyimide selon la revendication 1, dans lequel la réaction est effectuée pendant 3 ∼ 24 heures.
